# EUROPEAN PATENT APPLICATION

(11) **EP 0 862 203 A1**
(43) Date of publication of application: **02.09.1998**
(21) Application number: 98101622.3
(22) Date of filing: 30.01.1998
(51) Int. Cl.: H01L 21/3205

(54) **Method for fabricating a semiconductor memory capacitor**

(30) Priority: 31.01.1997 US 36998 P
(71) Applicant: Texas Instruments Incorporated, Dallas, Texas 75251 (US); HITACHI, LTD., Chiyoda-ku Tokyo, 101-10 (JP)
(72) Inventor:
(74) Representative: Schwepfinger, Karl-Heinz, Dipl.-Ing.

(57) **Abstract**

A method of forming a semiconductor structure such as an integrated circuit capacitor is disclosed herein. This method can be used in conjunction with the formation of a dynamic random access memory array. For example, the capacitor storage node 22 for each of the millions of memory cells can be formed from a metal material. For example, the storage node 22 can be made from tungsten, titanium, tantalum or a large number of other materials. A nitridation process is performed to form a conductive nitride layer disposed on the metal electrode 22. A dielectric layer 24 such as tantalum pentoxide or another high dielectric constant material can be formed on the conductive nitride layer. A conductive layer 26 can then be formed over the dielectric layer 24.

## Description

### FIELD OF THE INVENTION

This invention relates generally to semiconductor devices and specifically to an integrated circuit capacitor and a method of forming the same.

### BACKGROUND OF THE INVENTION

The increasing density of integrated circuits (e.g., dynamic random access memories) is increasing the need for materials with high-dielectric-constants to be used in electrical devices such as capacitors. Generally, capacitance is directly related to the surface area of the electrode in contact with the capacitor dielectric, but is not significantly affected by the electrode volume. The current method generally utilized to achieve higher capacitance per unit area is to increase the surface area/unit area by increasing the topography, such as in trench and stack capacitors using SiO₂ or SiO₂/Si₃N₄ as the dielectric. This approach becomes very difficult in terms of manufacturability for devices such as the 256 Mbit and 1 Gbit DRAMs.

An alternative approach is to use a high permittivity dielectric material. Many perovskite, ferroelectric, or high-dielectric-constant (hereafter abbreviated HDC) materials such as (Ba,Sr)TiO₃ (BST) usually have much larger capacitance densities than standard SiO₂-Si₃N₄-SiO₂ (ONO) capacitors. Various metals and metallic compounds, and typically noble metals such as platinum and conductive oxides such as RuO₂, have been proposed as the electrodes for these HDC materials.

As an example, Yamamichi et al. teach a (Ba, Sr) TiO₃ (BST) based stacked capacitor with a RuO₂/Ru/TiN/TiSiₓ storage node. "An ECR MOCVD (Ba,Sr) TiO₃ based stacked capacitor technology with RuO₂/Ru/TiN/TiSiₓ storage nodes for Gbit-scale DRAMs," 1995 IEDM 119. In this process, fully-planarized n-type polysilicon plugs were fabricated. Fifty nanometer titanium and 50 nm TiN layers were then deposited using a Ti metal target. This double layer was treated by RTA in N₂ at 700°C for 30 seconds to form a TiSiₓ silicide layer. Furthermore, a 50-100nm metal Ru layer was inserted between the RuO₂ and BST deposition.

Unfortunately, many of the HDC compatible materials tend to be difficult to process. While much engineering effort has gone into processing materials such as silicon, oxides and nitrides, less common materials have been the subject of less investigation. Accordingly, techniques to deposit and etch materials other than those commonly used are not well known. As a result, it is presently difficult to use HDC materials in anything but the simplest structures.

### SUMMARY OF INVENTION

The present invention provides an integrated circuit capacitor which can be used in a wide variety of devices including dynamic random access memories (DRAMs). As DRAM dimensions continue to shrink and the density corresponds to increase by a factor of four rule, the storage cell is getting small while the required storage charge remains about the same. Conventional oxynitride (N/O) dielectrics have smaller storage charge per unit area than high dielectric constant materials such as Ta₂O₅, Ba₁₋ₓSrₓTiO₃ (BST), and Pb₁₋ₓZrₓTiO₃ (PZT) . Thus, metal-insulator-metal (MIM) capacitors using the high dielectric constant materials have been proposed for supplying high storage charge density in a small storage cell. The present invention proposes self-aligned MIM capacitor formation in conjunction with high dielectric constant materials.

In one aspect, the present invention proposes a metal capacitor electrode and/or plug to replace the in-situ doped polysilicon plug which is used in most prior art dences. The metal electrode has lower contact resistance than in-situ doped polysilicon, and hence, the depletion problem for the capacitor is eliminated. As is known, this depletion problem exists because applied voltages can cause a depletion junction at the interface of the storage dielectric and the electrode. This depletion junction will couple with the storage capacitor thereby lowering the total capacitance of the element.

In addition, the present invention includes embodiments where a conductive nitride layer is formed on the metal electrode after it is patterned. This conductive nitride can include materials such as WSiₓN_{y} and WN/WSiₓ, as examples. In the preferred embodiment the electrode is formed by self-aligned processes through a plasma nitridation using N₂ or NH₃ plasma followed by rapid thermal nitridation (RTN) to increase the nitrogen content of the material. The self-aligned WSiₓN_{y} or WN electrodes will have higher oxidation resistance than previously proposed tungsten or polysilicon electrodes. These prior art materials tend to form WO₃ or SiO₂ low dielectric constant layers in the bottom electrode interface thereby lowering the capacitance of the element. If the storage node is completely made of metal, such as WN, WSiN, Pt, Ru or other, the thermal budget can be lowered by the elimination of the bottom electrode thermal processing, such as rapid thermal nitridation and silicidation since these processes sometimes have higher processing temperatures than dielectric deposition and anneal.

The present invention teaches a method of forming a semiconductor structure such as an integrated circuit capacitor which overcomes many of the problems of the prior art. This method is especially useful since it can be used in conjunction with the formation of a dynamic random access memory array. For example, the capacitor storage node for each of the millions of memory cells can be formed from a metal base electrode. The electrode can be made from tungsten, titanium, tantalum or a large number of other materials. A nitridation process is performed to form a conductive nitride layer disposed on the metal electrode. A dielectric layer such as tantalum pentoxide or another high dielectric constant material can be formed on the conductive nitride layer. A conductive layer can then be formed over the dielectric layer.

The present invention discloses a unique process for forming a self-aligned electrode. In addition, this self-aligned electrode has good oxidation resistance and high work function.

For example, conductive nitride electrodes have better oxidation resistance and higher work function than pure metal electrodes. These conductive nitrides can be used as direct capacitor electrodes or electrode diffusion barriers, which are typically needed for BST or PZT deposition. In particular, this self-aligned conductive nitride electrodes are suitable for the Ta₂O₅.

The electrodes of the present invention further provide a lower contact resistance than polysilicon electrodes. Low resistance is important for optimal operation of the circuit which includes the electrode. In addition, the lower resistance helps avoid the depletion problems which have been known to occur with polysilicon electrodes.

Yet another advantage is attained because the process uses a self-aligned step to form the conductive nitride regions. The self-aligned process is simple to perform and can be used with most any shape electrode. Use of the metal plug process will also avoid additional polysilicon processes.

### BRIEF DESCRIPTION OF THE DRAWINGS

The above features of the present invention will be more clearly understood from consideration of the following descriptions in connection with accompanying drawings in which:
Figure 1a is a cross-sectional view of a DRAM cell which can utilize the structure of the present invention and Figure 1b is an electrical schematic of the structure of Figure 1a;
Figures 2a-2f are cross-sectional views illustrating the formation of an integrated circuit electrode of the present invention;
Figures 3 and 4 illustrate alternate embodiment electrodes;
Figure 4 illustrates an alternate embodiment electrode;
Figures 5a-5c are diagrams of a DRAM circuit which can utilize the capacitor of the present invention; and
Figures 6a-6g are cross-sectional views illustrating one process flow for forming a DRAM which utilizes the capacitor of the present invention.

### DETAILED DESCRIPTION OF ILLUSTRATIVE EMBODIMENTS

The making use of the various embodiments are discussed below in detail.

However, it should be appreciated that the present invention provides many applicable inventive concepts which can be embodied in a wide variety of specific contexts. The specific embodiments discussed are merely illustrative of specific ways to make and use the invention, and do not limit the scope of the invention.

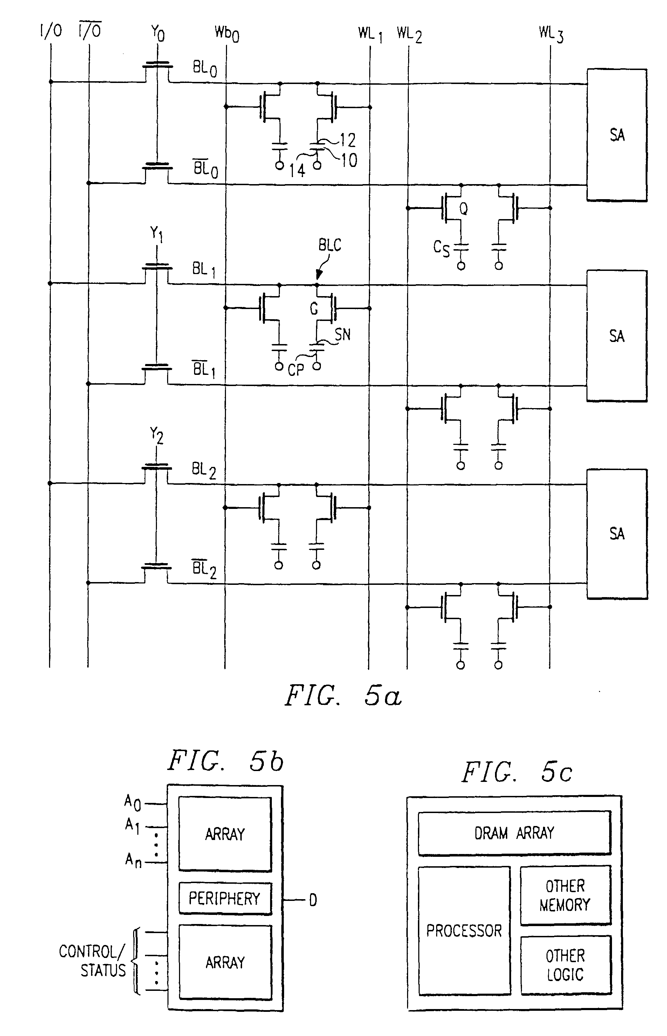

Each DRAM cell includes a pass transistor 10 coupled in series with a capacitor 12. The gate 14 of pass transistor 10 comprises one of the word lines WL of the memory array. (A memory array will be described in more detail with respect to Figure 5.) A shared source/drain region 16 of each pass transistor 10 is coupled to bit line 18. The other source/drain region 20 is coupled to the storage node electrode 22 of capacitor 12. Capacitor 12 further includes dielectric layer 24 and cell plate 26.

As applied to a DRAM cell, the present invention relates to an improved storage node 22. The capacitance of the DRAM cell can be expressed as Cₛ/A = e₀e₁/t, where Cₛ is the storage cell capacitance, A is the total surface area of the capacitor, t is the dielectric film thickness, and eg and eᵣ stands for vacuum and relative dielectric permitivities, respectively. As DRAM memory cells continue to shrink to include 64 megabits of information or more, conventional dielectrics such as N/O (SiN₃/SiO₂) can hardly supply sufficient storage charge due to the naturally low dielectric constant of the NO material. Complicated capacitor structures including multiple fins and disk have been proposed to supply a large enough surface area A to compensate for the low dielectric constant of the capacitor.

Another way to increase cell capacitance is to use a high dielectric constant (high-k or HDC) material for the cell capacitor. Materials such as tantalum pentoxide (Ta₂O₅), barium strontium titanate or simply BST (Ba₁₋ₓ, SrₓTiO₃), strontium titanate (SrTiO₃) and lead zirconium titanate or simply PZT (Pb1-xZrxTiO3) have been proposed for simple cell structures such as the simple stack cell (STC). In this context, a high dielectric constant material is defined as a material with a dielectric constant of 20 or greater. When specific materials (e.g., TaO₅, BST, PZT) are recited they are preferably HDC materials, although not necessarily.

High dielectric constant materials are typically grown by metal-organic chemical vapor deposition (MOCVD) in an oxygen ambient. The bottom electrode should have good oxidation resistance to withstand this processing without formation of an unwanted oxide layer which would lower the cell capacitance. Since conventional polysilicon bottom electrodes will form a silicon dioxide layer on the storage node after high-k dielectric film deposition, a metal or conductive nitride electrode should be coupled with the use of high-k dielectrics.

For the use of Ta₂O₆ for the storage dielectrics, a replacement CVD tungsten was proposed to be the bottom electrode on top of the polysilicon on top of the polysilicon storage node. See Kaga et al., "A 0.29 mm² MIM-CROWN Cell and Process Technologies for 1-Gigabit DRAMs," 1994 IEDM, p. 927. The tungsten electrode is oxidized at a temperature above 400°C, and hence, is not a good candidate for a high-k dielectric electrode. Other CVD metals such as platinum, palladium and aluminum or conductive nitrides such as TaSiN, TiSiN, WN, TiN, and TiAlN deposited on polysilicon have also been proposed for the bottom electrode. But these materials need additional patterning and etch processes. Furthermore, many of the above CVD processes are either not currently mature or even available. In order to have an easily integrated electrode and robust process, we propose a novel self-aligned bottom electrode process for integrated circuit capacitors which can be used with the high-k dielectrics.

Co-pending application Serial No. (TI-21537) discloses a self-aligned metal-insulator-metal capacitor which can use WN, WSiN, TiSiN, or TiAlN as the bottom electrode. During the capacitor formation process, the bottom electrode is selfaligned to form the storage node. These self-aligned processes are easily integrated into most any known DRAM process flow. If the surface layer is not made relatively thick (e.g., thicker than about 6-10 nm), however, it may not be able to withstand the oxidation ambient during Ta₂O₅ deposition.

In one aspect, the present invention proposes chemical vapor deposition (CVD) of WN, WSiN, TiSiN, or TiAlN for the bottom electrode. If nitride CVD processes are not available, the present invention can be implemented with currently developed metal CVD processes including tungsten and tungsten silicide. A nitridation process can then be applied to these deposited metal layers to form nitrided conductive electrodes. These electrodes have higher oxidation resistance than metals. The metal bottom electrode can directly replace the polysilicon plug often used with prior art structures thus eliminating a polysilicon process.

Mechanical stability for the metal storage node is also better than the mechanical stability of a polysilicon storage node. Hence, the metal storage node can have thinner film thickness than polysilicon for a cell structure other than a simple stack cell. Contact resistance for the metal storage node is also lower than convention polysilicon plugs and storage nodes. Furthermore, interfacial depletion problems are not present with metal storage node.

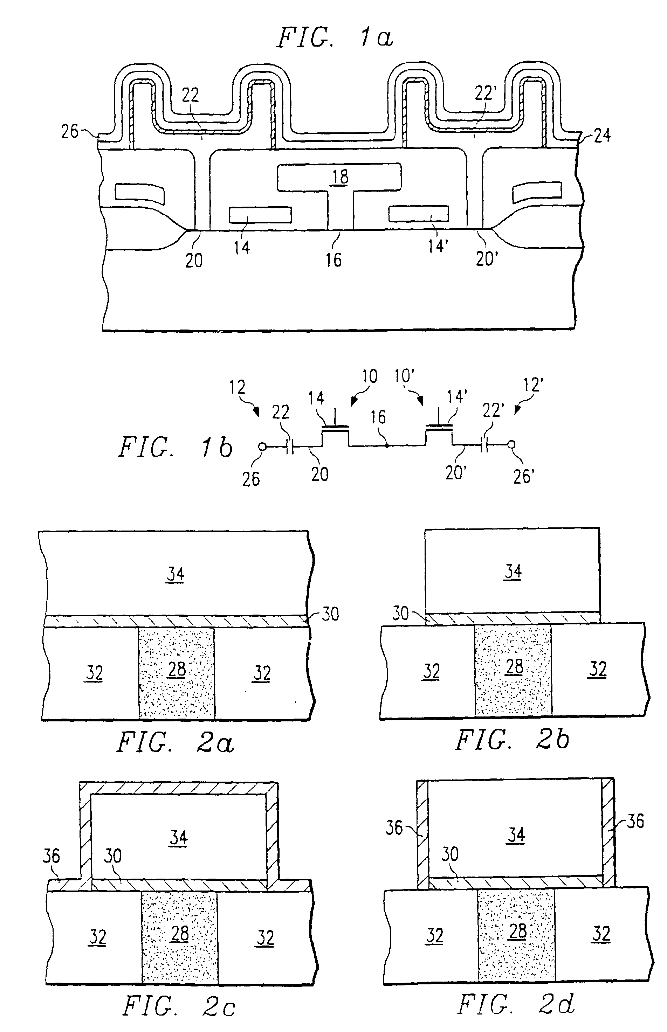

A method of forming an integrated circuit structure of the present invention will now be described with respect to Figures 2a-2f. Referring now to Figure 2a, a plug 28 is formed through patterning and etching. The plug 28 material can be doped polysilicon or a metal. The nature of the plug is not critical to the present invention and can, in fact, be eliminated completely. For example, metal layer 30 can be formed directly on the substrate (not shown).

In the example of Figure 2a, plug 28 is formed within an insulating layer 32. In the preferred embodiment, insulating layer 32 comprises an oxide layer (e.g., formed from the decomposition of tetraethyloxisilane or TEOS) on a BPSG (borophosphosilicate glass) layer. Oxides formed from TEOS tend to have better oxide properties than BPSG in terms of breakdown, leakage, and density. Hence, an oxide 32 formed from TEOS is deposited on top of BPSG in the preferred embodiment.

Base metal layer 30 is deposited over the insulating region 32 and plug 28. Base metal layer 30 can be formed by chemical vapor deposition (CVD), physical vapor deposition (PVD), or plasma enhanced chemical vapor deposition (PECVD), as examples. In the preferred embodiment, metal layer 30 is a material that is relatively good for oxidation resistance and has high work function. The preferred materials for base metal layer 30 are listed in Table 1. It is noted, however, other metals may alternatively be used. For example, other transition metals such as platinum (Pt), ruthenium (Ru), iridium (Ir), cobalt (Co), and molybdenum (Mo) and conductive oxide materials including ruthenium oxide (RuO₂), iridium oxide (IrO₂) and (La,Sr) CoO₃ can be used for base metal layer 30. The base metal layer 30 can be formed from the same material as plug 28, but this is not a requirement.

A sacrificial layer 34 is formed over metal layer 30. The composition of this layer is not critical since the layer will be removed during subsequent processing (as illustrated in Figure 2e). In the preferred embodiment, an oxide (e.g., SiO₂) is used for the sacrificial layer 34. A photoresist region (not shown) can be used to make the patterned sacrificial layer 34 into a hard mask. This mask can then be used to etch the base metal layer 30 as illustrated in Figure 2b.

Referring now to Figure 2c, a metal layer 36 is deposited on the structure. The metal layer 36 preferably surrounds the top and side surfaces of the sacrificial region 34. The choices for the metal layer 36 are the same as those listed above for base metal layer 30. In the preferred embodiment, metal layer 36 comprises the same material as base metal layer 30. This feature, however, is not a requirement. In other words, metal layer 36 can comprise a different material than base metal layer 30.

A portion of the metal layer 36 on the top surface of the sacrificial region 34 is removed as illustrated in Figure 2d. This removal will expose the top surface of the sacrificial region 34 but will leave a portion of the metal layer 36 on the side surfaces of the sacrificial region. In the preferred embodiment, this removal step is accomplished with an anisotropic etch-back of metal layer 36. Sacrificial region 34 can then be removed leaving the metal storage node 22. The storage node 22 is illustrated in Figure 2e.

After the metal storage node 22 is formed, a nitridation process can be performed. For example, a conductive nitride electrode can be formed through a plasma nitridation using N₂ or NH₃ plasma followed by a rapid thermal anneal (RTN) to increase the nitrogen content in the material. The resultant self-aligned electrode will have higher oxidation resistance than previously proposed tungsten or polysilicon storage nodes.

Several choices of materials and processes for the storage node 22 and plug 28 are provided in Table 1. It is noted that the plug 28 can be either conventional polysilicon (e.g., in situ doped polysilicon) or the same material as the storage node 22. In a less preferred embodiment, plug 28 can comprise a different metal material than the storage node 22.

**Table 1**

| Storage Node 22 Matemal | Approximate x Range | Preferred Processes | Approximate Temperature (°C) | Nitridation |
|---|---|---|---|---|
| W/TiN | -- | CVD, PVD | 350-450 | N₂ or NH₃ plasma + optional RTN |
| W/WSiₓ | 0.5<x<2.5 | CVD, PVD | 350-450 | N₂ or NH₃ plasma+RTN |
| WN | -- | CVD, PECVD, PVD | 400-700 | -- |
| WSiₓ | 0.5<x<2.5 | CVD, PVD | 500-700 | N₂ or NH₃ plasma+RTN |
| WSiₓ/TiN | 0.5<x<2.5 | CVD, PVD | 500-700 | N₂ or NH₃ plasma+RTN |
| WSiₓ/Nᵥ | 0.3<x<2.0 | CVD, PECVD | 500-700 | -- |
| | 0.3<y<3.0 | | | |
| TaSiₓ | 0.5<x<2.5 | CVD, PVD | 450-650 | N₂ or NH₃ plasma+RTN |
| TaSiₓNᵥ | 0.3<x<2.0 | CVD, PECVD | 500-700 | -- |
| | 0.3<y<3.0 | | | |
| TiSiₓ | 0.5<x<2.5 | CVD, PVD | 450-650 | N₂ or NH₃ plasma+RTN |
| TiSiₓNᵥ | 0.3<x<2.0 | CVD, PECVD | 500-700 | -- |
| | 0.3<y<3.0 | | | |

It is noted that a SiON layer (not shown) may be formed on the surface of the insulating region 32 during the nitridation process. Since SiON is not conductive, any SiON layer should have no effect on the cell array. That is, the SiON layer should not induce any leakage in the capacitor.

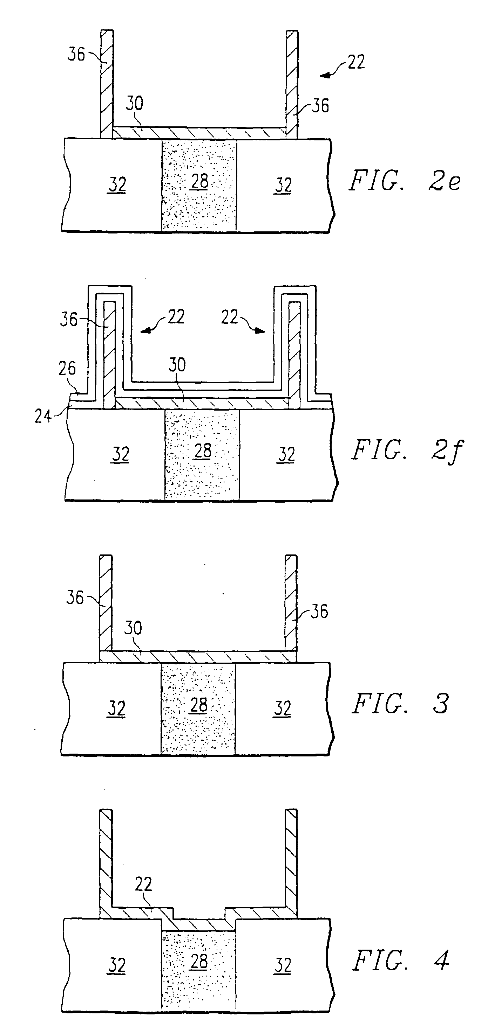

Referring now to Figure 2f, a dielectric layer 24 can be formed over the storage node 22. Dielectric layer 22 can comprise an oxide, a nitride or a combination of the two (e.g., an oxide-nitride-oxide or oxide-nitride stack). One of the advantages of the present invention, however, is that a wide variety of other dielectrics can alternatively be used. The present invention can also be used with high-dielectric-constant materials including tantalum pentoxide (Ta₂O₅), barium strontium titanate or simply BST (Ba₁₋ₓSrₓTiO₃), strontium titanate (SrTiO₃) and lead zirconium titanate or simply PZT (Pb₁₋ₓZrₓTiO₃). As noted above, these materials are not compatible with simply silicon structures. But these materials can be used with the structure described herein.

As also illustrated in Figure 2f, top electrode 26 is formed over dielectric layer 24. Top electrode 26 can comprise just about any conductive material. The only criteria is that the electrode material be physically (e.g., adhesively, thermally) compatible with dielectric material 24. Form example, electrode 26 can comprise silicon (e.g., polysilicon), a metal (e.g., aluminum, copper, palladium, platinum, ruthenium, gold, silver, tantalum, titanium, molybdenum, cobalt, tungsten), silicide (e.g., TaSiₓ, TiSiₛ, AlSiₓ, Wsiₓ, CoSiₓ, MoSiₓ, an alloy silicide), a conductive nitride (e.g., titanium nitride, titanium aluminum nitride, tantalum silicon nitride, tungsten silicon nitride, tungsten nitride, molybdenum nitride, ruthenium nitride, tin nitride, zirconium nitride), a conductive oxide (e.g., RuO₂, SnO, ZO, IrO), or other conductive materials (e.g., a carbide such as tantalum carbide, a boride such as titanium boride). Figure 3 illustrates an alternative embodiment storage node 22. In this embodiment, the vertical layer 36 is formed on top of bottom layer 30 instead of next to layer 30 as illustrated in Figure 2e. For example, this structure can be formed by isotropically etching sacrificial layer 34 (Figure 2b) after patterning bottom electrode layer 30. Alternatively, sacrificial layer 34 (Figure 2b) could be removed and replaced with another sacrificial layer (not shown). The embodiment of Figure 3 has the advantage that the base metal layer 30 can be patterned to a larger dimension.

Figure 4 illustrates another alternative embodiment integrated circuit structure. In this example, storage node 22 includes a portion which is formed in a recess within insulating region 32. The interface between plug 28 and storage node 22 is therefore disposed within this recess.

The method and structure of the present invention provide an integrated circuit capacitor which can be used in a wide variety of applications. While described thus far in the context of a dynamic random access memory (DRAM), the present invention can also be used to form a capacitor for an analog-to-digital (A/D) converter, a digital-toanalog (D/A) converter, or just about any other integrated circuit chip. But DRAMs tend to be the device which has the most stringent requirements for capacitors. Therefore, the application of the present invention with DRAMs will be more thoroughly explored.

A simplified schematic diagram of a DRAM array is illustrated in Figure 5a. As shown, a plurality of memory cells can be formed in an array of rows and columns.

Figure 5a illustrates only six bit lines BL and four word lines WL in what in actuality would likely be a much larger array. The pass transistor Q of each memory cell has a gate G coupled to a word line WL and a source/drain region BLC (for bit line contact) coupled to a bit line BL. The transfer gate G of one pass transistor Q will be electrically coupled to the word line WL for a number of other pass transistors.

Figure 5a also illustrates some of the peripheral circuitry which would be included in a memory array. For example, each pair of bit lines BL and BL(bar) is coupled to a sense amplifier SA. The bit lines BL and BL(bar) are also coupled to input/outline lines I/O and I/O(bar) through select transistors Y₀-Y₂. Other peripheral circuitry such as the row decoders, column decoders, address buffers, I/O buffers and so on are not illustrated here. For the purposes of this invention, the memory cell and fabrication method are independent of the memory architecture.

As an example, the memory array can be designed as an asynchronous memory or as a synchronous memory. A synchronous memory can be timed with an internal clock (not shown) or an external clock (not shown). The device can have a single external data terminal or multiple external data terminals (i.e., wide word). The array can include a total of 4 megabits, 16 megabits, 64 megabits, 256 megabits, one gigabit or more.

A simplified block diagram of a memory device is shown in Figure 5b. The internal device circuitry includes an array and peripheral circuitry. The array may be divided into a number of blocks depending upon the device architecture. Sense amplifiers may be interleaved within the array blocks.

Several external terminals are illustrated in Figure 5b. Address terminals A₀, A₁, ..., An are provided for receiving row and column addresses. These terminals may be multiplexed (i.e., a first address is applied at a first time and a second address applied at a second time). A single data terminal D is also illustrated. This terminal may comprise an input, an output or an input/output. Other data terminals may also be included. For example, a wide word device will have multiple data terminals. In general, these terminals are provided for receiving input signals from circuitry (not shown) external of the array and for providing output signals to circuitry (not shown) external of the array.

Figure 5b also illustrates a number of control/status signals. These signals are used to operate the memory device. For example, an asynchronous memory device may be operated by applying chip select, row address strobe and column address strobe signals. Other signals may indicate whether a read or write operation is being performed. In a synchronous device, one of the control signals may be a clock signal. Status signals may provide information about the device to the external system. For example, the device may include a signal indicating whether a refresh operation is taking place or which portion of the array is being accessed.

A memory array of the present invention could also be embedded in a larger integrated circuit device. An embedded memory is a memory array and its associated control circuitry on the some integrated circuit as a substantial amount of logic. Figure 5c has been included to illustrate a simple block diagram of an embedded memory. In this example, a DRAM array is included along with a processor (e.g., microprocessor, digital signal processor, specialty processor, microcontroller), another memory array (e.g., SRAM, non-volatile memory such as EPROM, EEPROM, flash memory, PROM, ROM, another DRAM array) and other logic circuitry. These particular blocks have been chosen to illustrate the wide variety of other logic which could be included. Any combination of the devices could be included.

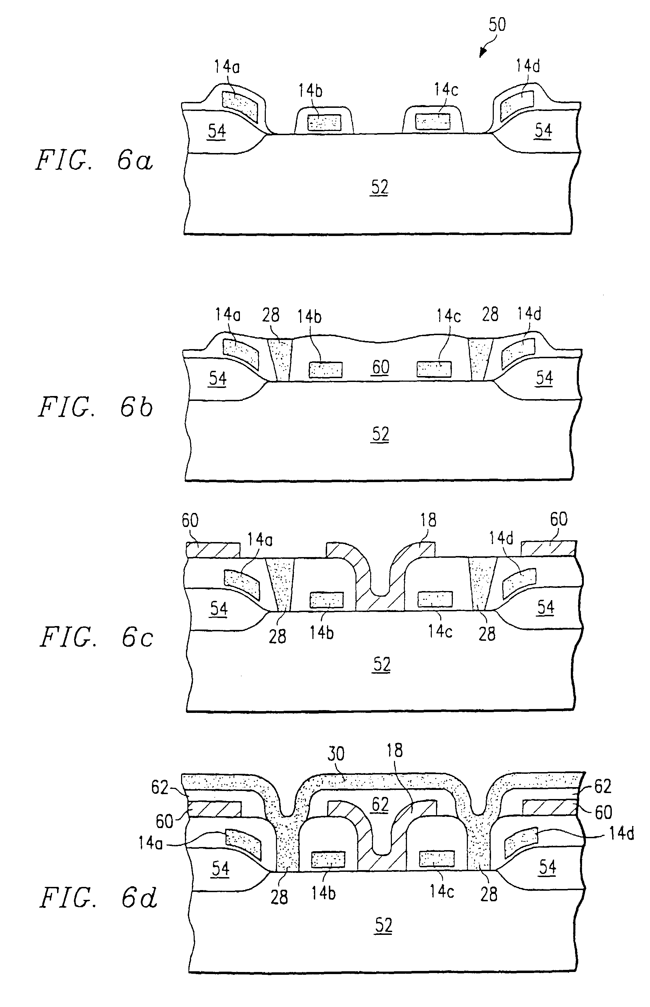

An exemplary method of forming a DRAM device will now be described with respect to Figures 6a-6j. This method is included to illustrate how the present invention could be easily incorporated in a DRAM process flow.

Referring now to Figure 6a, a DRAM device 50 will be formed in a semiconductor substrate 52. Figure 6a illustrates field isolation regions 54 and four word line/pass gates 14. While illustrated with field isolation 54, it is also noted that other isolation techniques such as trench isolation can be used. Pass transistors 14b and 14c will form the gates of the two memory cells which will be illustrated in these drawings. Word lines 14a and 14d, on the other hand, will serve as the pass transistors for gates in other rows of the device.

Referring now to Figure 6b storage plate plugs 28 are formed. Regions 28 can be formed, for example, by depositing a layer of oxide material over the word lines 14 and then etching contact holes through the oxide of 60. A self-aligned contact etch can be performed by first surrounding each word line 14 with a nitride (not shown) and etching the overlying oxide 60. As described above the plugs 28 can be formed from polysilicon or a metal.

Bit line regions 18 are formed in Figure 6c. As illustrated, in this example, the two memory cells being fabricated will share a single bit line (see Figure 5a for the electrical schematic). While it is not critical to this invention, the bit line may comprise any conducive material such as metal silicide, silicon or a metal.

Referring now to Figure 6d, formation of the storage node of the capacitors is continued. An insulating layer 62 is formed over the bit lines 18. Using standard patterning and etching techniques, a contact hole is formed through insulating layer 62 to expose plug 28. Subsequently a second conductive layer 30 is formed over the insulating layer and so as to contact plugs 28. The conductive layer 30 preferably comprises a metal or metal nitride as described above with respect to Figures 2a-2f.

Referring now to Figure 6e dummy masking layer 34 is formed over the conductive layer 30. Using standard patterning and etching techniques, masking layer 34 is patterned so as to protect the portion of layer 30 which will become part of the storage node 22 (Figure 1). Masking layer 34 and conductive layer 30 are then etched to create the portion of the storage node 22 structure illustrated in Figure 6e.

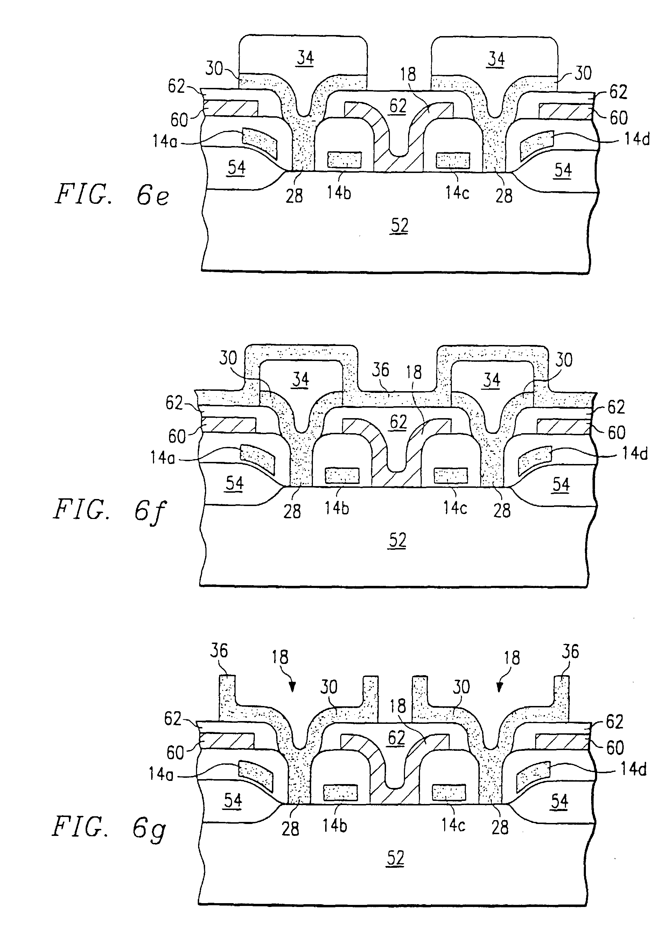

Referring now to Figure 6f, a second conductive layer 36 is formed over the structure. Conductive layer 36 will be as described above with respect to Figures 2a-2f material as before, layer 36 surrounds dummy layer 34. The layer 36 can then be anisotropically etched so as to leave side wall along the dummy layers 34. After the dummy layer 34 is removed, a cylindrical storage node 22 will remain as illustrated in Figure 6g. The nitridation process described earlier can now be performed.

Using the prior art processing techniques, a standard ONO dielectric could then be formed over the storage node 22 to serve as capacitor dielectric. In the performed embodiment, however, a high dielectric constant material such as tantalum pentoxide, BST, or PZT will be used. The formation of a dielectric layer and second conductive layer can be performed as discussed above with respect to Figure 2f.

It is noted that a number of additional steps will be required before the DRAM device is completed. Since these steps are not critical to the present invention, they will not be described here beyond the acknowledgment of their existence.

While described thus far with respect to integrated circuit capacitors, the present invention can also be utilized with other integrated circuit elements. For example, the concepts of the present invention cam be applied to metal gate and diffusion and oxidation barrier applications in other integrated circuits such as application specific integrated circuits (ASIC) and logic devices. Metal gates can be formed from materials such as tungsten, titanium, molybdenum/tungsten silicon nitride, titanium silicon nitride, titanium nitride, molybdenum nitride, tantalum silicon nitride, or tantalum nitride. These gates can be formed with or without polysilicon/oxide (gate oxide) . Examples of diffusion barrier applications are tungsten silicon nitride, tungsten nitride, titanium silicon nitride, titanium nitride, molybdenum nitride, tantalum silicon nitride, and tantalum nitride.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A method of forming a semiconductor structure, said method comprising the steps of:
depositing a metal base electrode;
after the metal base electrode is deposited, nitriding the metal base electrode to form a conductive metal nitride layer;
forming a dielectric layer on the conductive nitride layer; and
forming a conductive layer over the dielectric layer.

2. The method of Claim 1, wherein the step of providing a metal base electrode comprises providing a tungsten base electrode.

3. The method of Claim 1, wherein the metal electrode layer is formed from a material selected from the group consisting of titanium, aluminum, molybdenum, cobalt, and alloy thereof.

4. The method of Claim 1 wherein the metal electrode layer is formed from a material selected from the group consisting of zirconium, ruthenium, platinum, iridium, RuO₂, Ir-O₂ and (La,Sr)COO₃.

5. The method of Claim 1, wherein the metal electrode layer is formed from a silicide.

6. The method of Claim 1, wherein said nitriding step comprises a rapid thermal nitridation step.

7. The method of Claim 6, wherein the nitriding step is performed at a temperature between about 700°C and about 800°C,

8. The method of Claim 6, wherein the nitriding step is performed at a pressure between about 100 torr and about 760 torr.

9. The method of Claim 1, wherein the dielectric layer comprises a high dielectric constant material.

10. The method of Claim 1, wherein the dielectric layer comprises a tantalum pentoxide.

11. The method of Claim 1, wherein the dielectric layer comprises a lead zirconium titanate.

12. The method of Claim 1, wherein the dielectric layer comprises a barium strontium titanate.

13. The method of Claim 1, wherein the dielectric layer comprises a strontium titanate.

14. The method of Claim 1, and further comprising the step of applying an 02 plasma to said device after the dielectric layer is formed.

15. The method of Claim 14, and further comprising the step of performing an ozone anneal after the dielectric layer is formed.

16. A method of forming an integrated circuit capacitor, the method comprising the steps of:
providing a base metal layer;
forming a sacrificial region over the metal layer, the sacrificial region having a top surface and side surfaces;
forming a metal layer on the sacrificial region, the metal layer surrounding the top and side surfaces of the sacrificial region;
removing a portion of the metal layer on the top surface of the sacrificial region so as to expose the top surface of the sacrificial region wherein a portion of the metal layer on the side surfaces of the sacrificial region is not removed;
removing the sacrificial layer;
nitriding exposed portions of the base metal layer and the metal layer to form a conductive nitride layer;
forming a dielectric layer over the conductive nitride layer; and
forming a conductive region over the dielectric layer.

17. The method of Claim 16, wherein the step of forming a dielectric layer comprises the step of forming a dielectric layer with a high dielectric constant.

18. The method of Claim 16, wherein the metal layer includes tungsten.

19. The method of Claim 16, wherein the metal layer includes a material selected from the group consisting of titanium, aluminum, molybdenum, cobalt, platinum, iridium, ruthenium oxide, iridium oxide, (La,Sr) COO3, zirconium, ruthenium, molybdenum, and alloys thereof.

20. The method of Claim 16, wherein said step of forming a conductive nitride layer comprises a rapid thermal nitridation step.

21. The method of Claim 16, wherein the dielectric layer is selected from the group consisting of tantalum pentoxide, lead zirconium titanate, barium strontium titanate, and strontium titanate.

22. The method of Claim 16, wherein conductive region comprises a meterial selected from the group consisting of titanium nitride, titanium aluminum nitride, tantalum silicon nitride, tungsten silicon nitride, tungsten nitride and molybdenum nitride.

23. A method of forming a dynamic random access memory cell, the method comprising the steps of:
providing a silicon layer;
forming a pass transistor in a face of the silicon layer, the pass transistor including first and second source/drain regions and a conductive gate;
forming a bit line in electrical contact with the first source/drain regions;
forming a base metal electrode in electrical contact with the second source/drain region;
nitriding the base metal electrode to form a conductive metal nitride storage node;
forming a dielectric layer on the storage node; and
forming a conductor on the dielectric layer.

24. The method of Claim 23, wherein the step of forming a base metal electrode comprises forming a non-planar base metal electrode.

25. The method of Claim 23, wherein the step of forming a dielectric layer comprises forming a dielectric layer of a material with a high dielectric constant.

26. The method of Claim 23 wherein the base metal electrode includes tungsten.

27. The method of Claim 23, wherein the step of nitriding comprises a rapid thermal nitridation step.

28. A method of forming an integrated circuit capacitor, the method comprising the steps of:
depositing a first conductive nitride base layer;
forming a sacrificial region over the base layer, the sacrificial region having a top surface and side surfaces;
forming a second conductive nitride layer on the sacrificial region, the second layer surrounding the top and side surfaces of the sacrificial region;
removing a portion of the second layer on the top surface of the sacrificial region so as to expose the top surface of the sacrificial region wherein a portion of the second layer on the side surfaces of the sacrificial region is not removed;
removing the sacrificial layer;
forming a dielectric layer over the base layer and the second layer; and
forming a conductive region over the dielectric layer.

29. The method of Claim 28 wherein the second conductive nitride layer is selected from the group consisting of Wn, WSiN, TiSiN, TiN and TiAIN.

30. The method of Claim 28, wherein the dielectric layer comprises a high dielectric constant material.
